# EUROPÄISCHE PATENTSCHRIFT

(11) **EP 0 837 606 B1**
(45) Veröffentlichungstag und Bekanntmachung des Hinweises auf die Patenterteilung: **07.11.2001**
(21) Anmeldenummer: 97116058.5
(22) Anmeldetag: 16.09.1997
(51) Int. Cl.: H04N 7/16, H04N 5/44, G06F 1/00, G06F 9/445

(54) **Interaktive Informationsübertragungsanlage für PC-TV**
Interactive information transmission installation for PC-TV
Installation interactive de transmission d'information pour PC-TV

(30) Priorität: 17.10.1996 DE 29618017 U
(43) Veröffentlichungstag der Anmeldung: 22.04.1998
(73) Patentinhaber: Prodac Media AG, 50858 Köln (DE)
(72) Erfinder: Fleu, Thomas, 52134 Herzogenrath (DE)
(74) Vertreter: Godemeyer, Thomas, Dr.

(56) Entgegenhaltungen:
- DE-U- 9 107 565
- US-A- 4 621 259
- ANONYMOUS: "Program-Controlled Electronic Switch for Tape Backup" IBM TECHNICAL DISCLOSURE BULLETIN, Bd. 31, Nr. 6, November 1988, NEW YORK, US, Seiten 425-426, XP002054378

## Beschreibung

Die Erfindung betrifft eine interaktive Informationsübertragungsanlage umfassend eine Kopfstation 2, mindestens eine Steuerung 1, ein oder mehrere mit der Kopfstation verbundene Wiedergabegeräte 6,7 und ein Antennennetzwerk 4. Die Informationsübertragungsanlage ist für Beherbergungs- und Pflegeeinrichtungen bestimmt, insbesondere für Hotels, Krankenhäuser, Altersheime und Wohnheime in denen die Unterhaltungswünsche verschiedener Teilnehmer berücksichtigt werden müssen.

Aus dem Stand der Technik ist bereits eine Informationsübertragungsanlage bekannt. So beschreibt die DE-U-94 10 248.1 eine interaktive Übertragungsanlage, bei der ein in der Kopfstation bereitgestelltes Programm auf ein Steuersignal eines Teilnehmers in den Gästezimmern nur an diesen Teilnehmer abgegeben wird und dieser Teilnehmer die Steuerung des Programms durch eine direkte Steuerung des TV-Gerätes und oder des Telefons auf dem Gästezimmer vornehmen kann.

Aus der DE-U1 91 07 565.3 ist eine weitere Informationsübertragungsanlage bekannt, die eine Kopfstation, eine Gebührenzähleinrichtung, eine Steuerung, an die Kopfstation angeschlossene bei den Teilnehmern aufgestellte Wiedergabegeräte und ein Netzwerk enthält. Die Wiedergabegeräte sind insbesondere Fernsehgeräte und sollen die von den Videoabspielgeräten über die Kopfstation abgestrahlten Informationen auf mindestens einer spezifischen Sendefrequenz wiedergeben. Dabei sind jedem Fernsehkanal mindestens 2 Videoabspielgeräte zugeordnet. Die Videoabspielgeräte sind so geschaltet, daß am Ende einer Informationssendung, die von einem Abspielgerät stammt, ein anderes Abspielgerät selbsttätig mit der Wiedergabe der darauf befindlichen Informationssendung beginnt.

Die vorliegende Erfindung ist eine Weiterentwicklung der in der DE-U-94 10 248.1 beschriebenen interaktiven Informationsübertragungsanlage.

Der zunehmende Einsatz von Personalcomputern führt dazu, daß in Beherbergungsunternehmen wie Hotels, Krankenhäuser, Altersheimen und Wohnheimen, den Gästen Personalcomputer zur Verfügung gestellt werden, beispielsweise auch in Form von sogenannten PC-TVs. Hierbei handelt es sich um Personalcomputer, die gleichzeitig auch zum Fernsehempfang geeignet sind. Beim Einsatz der PCs tritt insbesondere das Problem auf, daß Konfigurationen, die durch die Benutzer verändert wurden, oder vertrauliche Informationen, die von den Benutzern auf den PCs abgespeichert oder nicht ausreichend gelöscht worden sind, vom nächsten Benutzer eingesehen werden können. Weiterhin kann der Benutzer bei den bisher verwendeten PC-TVs auch die Konfiguration so ändern, daß der Computer vom nächsten Benutzer nicht mehr gestartet werden kann. Weiterhin besteht die Gefahr, daß durch häufig wechselnde Benutzer und fehlende Kontrollmöglichkeiten Computerviren eingeschleppt werden, die das Betriebssystem zerstören können.

Aufgabe der Erfindung ist es daher eine Informationsübertragungsanlage zur Verfügung zu stellen, die die vorgenannten Nachteile nicht aufweist und bei der insbesondere gewährleistet ist, daß die Basiskonfiguration des PC-TVs, das den Gästen zur Verfügung gestellt wird für den nächsten Benutzer unverändert erhalten bleibt.

Diese Aufgabe wird gelöst durch eine interaktive Informationsübertragungsanlage bei der die Wiedergabegeräte 6,7 mindestens ein PC-TV 7 umfassen, in welchem mindestens 2 Festplatten 8,9 angeordnet sind und eine Kopie der Basiskonfiguration des PC-TVs auf einer Festplatte 8 abgelegt ist, die nur durch einen elektronischen Schalter mit dem PC-TV verbunden werden kann.

Hierdurch wird gewährleistet, daß Veränderungen des Benutzers an der Basiskonfiguration des PCs die Funktionsfähigkeit des PC-TVs nicht stören. Die PC-TVs enthalten zwei voneinander unabhängige Festplatten, wobei sich auf einer zweiten Festplatte die Basiskonfiguration des PC-TVs als Kopie befindet. Diese Festplatte kann vom Benutzer nicht angesteuert werden. Bei Abmeldung des Gastes in der Hotelzentrale wird über einen elektronischen Schalter, der ferngesteuert werden kann oder direkt am PC-TV angeordnet ist, die für den Gast zugängliche Festplatte 9 des PC-TV mit den Dateien der Festplatte 8 überschrieben und so die ursprüngliche Basiskonfiguration des PC-TVs wiederhergestellt.

In einer besonderen Ausführungsform ist der elektronische Schalter zur Verbindung der Festplatte mit der Basiskonfiguration auf einer Erweiterungskarte im PC-TV angeordnet. Der elektronische Schalter kann auch mit der Kopfstation über ein Netzwerk verbunden sein. Vorzugsweise wird zur Steuerung der Festplatte eine Software verwendet, die beispielsweise in einem ROM der Erweiterungskarte des PC-TVs angeordnet ist.

Ziel dieses Systems ist es, in einem PC einen Datenträger zu integrieren, auf den der Benutzer nicht unmittelbar zugreifen kann, der aber trotzdem von einer speziellen Software angesprochen werden kann. Dadurch ist es z.B. möglich auf der geschützten Festplatte ein Backup der zugänglichen Festplatte zu halten, das bei Bedarf wieder auf die zugängliche Festplatte kopiert werden kann. Auf diese Weise wird sichergestellt, daß z.B. ein Gast in einem Hotel die gleiche Ausgangskonfiguration des PCs vorfindet, unabhängig davon in welchem Zustand der vorherige Gast den PC zurückgelassen hat.

Um dieses sicherzustellen gab es bisher verschiedene Möglichkeiten. So wurde z.B. der PC vor jeder neuen Benutzung durch einen neuen Gast manuell durch das Personal neu konfiguriert. Es wurde ferner eine Basiskonfiguration lokal auf einem PC gehalten, die per Fernsteuerung installiert werden konnte. Hierbei wurde jedoch die Basiskonfiguration auf nur einer Festplatte des Rechners in einer zweiten Partition oder verschlüsselt abgelegt. Diese Variante hat jedoch den erheblichen Nachteil, daß es dem Benutzer möglich ist, durch Einsatz von frei erhältlicher Software auch Zugriff auf die Basiskonfiguration zu erhalten, so daß diese durch den Benutzer manipuliert oder zerstört werden kann. Ein sicherer Weg zum Schutz der Basiskonfiguration besteht nur darin, erfindungsgemäß dem Betriebssystem des PCs den Zugriff auf die Basiskonfiguration unmöglich zu machen.

Dies wird nur durch zwei getrennte Festplatten erreicht, wobei die Basiskonfiguration auf einer zweiten Festplatte abgelegt wird, die durch einen elektronischen Schalter mit dem PC verbunden oder von diesem getrennt werden kann. Dieser Schalter befindet sich bevorzugt auf einer Erweiterungskarte im PC, die außerdem mit der Informationsübertragungsanlage verbunden ist. Der Schalter kann nun entweder durch einen Befehl über die Übertragungsanlage oder durch einen auf dem PC befindliche spezielle Software aktiviert werden. Da die zweite Festplatte dem Betriebssystem des PCs aber unbekannt ist, kann selbst nach Herstellung der Verbindung zwischen Festplatte und PC auf die Festplatte nur über speziell dafür entwickelte Software zugegriffen werden. Diese kann beispielsweise in einem ROM auf der Erweiterungskarte abgelegt sein.

Durch diese Anordnung wird sichergestellt, daß sensible Daten, die der Gast unter Umständen auf dem PC gespeichert hat, gelöscht werden und es wird weiterhin die Funktionssicherung des Computers und seiner Peripheriegeräte gewährleistet. Auch ist es möglich, den PC-TV über ein Modem von außen zu steuern und diese Vorgänge über eine entsprechende Steuereinheit abzuwickeln.

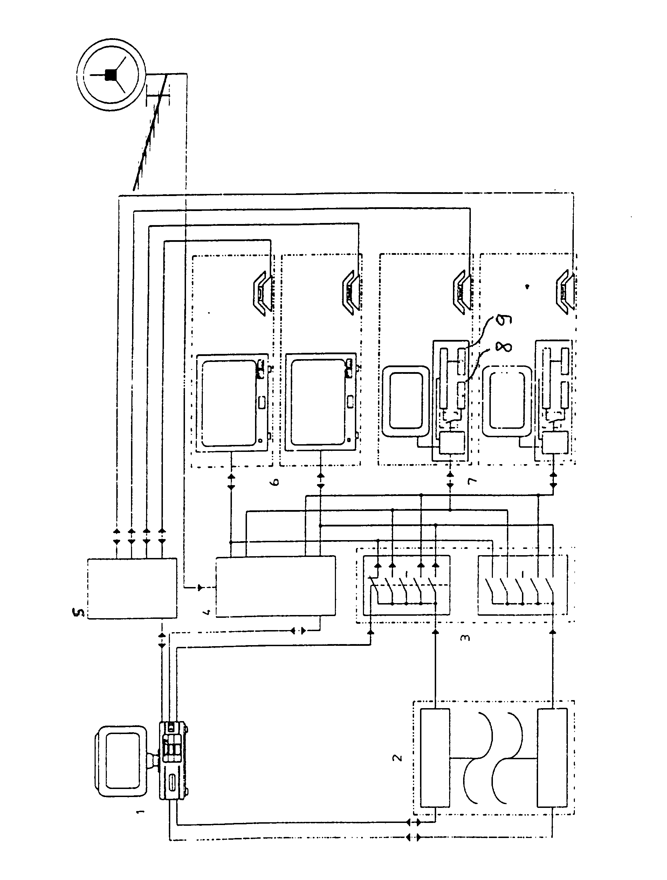

Figur 1 zeigt die interaktive Informationsübertragungsanlage gemäß der Erfindung. Die Informationsübertragungsanlage besitzt eine Steuerung 1, die im allgemeinen von einem Computer ausgeführt wird. Dieser ist verbunden mit Kopfstation 2. Die Kopfstation 2 enthält verschiedene Wiedergabegeräte wie CD-I-Player oder Computer mit entsprechenden Abspieleinrichtungen wie ROM-Laufwerk etc. Die Signale aus der Kopfstation gelangen zu einem Signalquellenschalter oder Modulator 3, der das gewählte Programm nur einem Teilnehmer in einem bestimmten Gästezimmer zuordnet, währenddessen die anderen Teilnehmer nicht auf dieses Programm zugreifen können. Dabei können die Signale, die von der Kopfstation 2 abgegeben werden, auch auf das vom Antennennetzwerk 4 kommende Signal, wie dies in Figur 1 gezeigt ist, aufgeschaltet werden. Das Steuersignal des Teilnehmers kann einmal über das Fernsehgerät 6 oder die PC-TVs 7 im Gästezimmer abgegeben werden, von wo es dann über das Antennennetzwerk 4 zur Steuerung 1 geleitet wird. Andererseits ist es auch möglich eine Steuerung über das Telefon im Gästezimmer vorzunehmen. Dann wird das Signal direkt über die Telefonanlage 5 zur Steuerung 1 geführt. Auf diese Weise sind auch schnellere Operationen, wie sie bei Geschicklichkeitsspielen benötigt werden, möglich.

In beiden Fällen wird die Wahl des Teilnehmers der Steuerung 1 durch einen Datentransfer entweder auf dem bestehenden Antennennetz 4 oder On-Line über Telefon mitgeteilt. Die Steuerung 1 startet dann exklusiv für den betreffenden Teilnehmer das entsprechende Interaktivsystem und schaltet das zugehörige Ausgangssignal aus der Kopfstation 2 auf einen Übertragungskanal auf, der dann ausschließlich von diesem Gerät zu empfangen ist.

Die Ziffer 7 zeigt den erfindungsgemäß verwendeten PC-TV, indem mit den Ziffern 8 und 9 zwei Festplatten bezeichnet sind. Die Festplatte mit der Ziffer 9 ist direkt mit dem Betriebssystem des Computers verbunden, während die Festplatte mit der Ziffer 8 nur über den Schalter gesteuert werden kann.

Als interaktive Funktionen, die der Teilnehmer über das Steuerungselement auf die Kopfstation ausüben kann, sind denkbar die Steuerung der Abspielgeräte wie der CD-I-Player, der Videoplayer (Vorlauf, Rücklauf, Zeitlupe, Pause, Steuerung einer Voice-Mail-Box, einer Fax-Box und eines Flugterminals). Ferner können als weitere interaktive Funktionen solche ausgeführt werden, die einzelne Programme oder Datenbanken steuern wie z.B. ein Hotelinformationssystem, Stadtpläne, Universallexika, Wörterbücher, Spiele, Verkehrsinformationssysteme und Multimediadatenbanken.

Durch die Verwendung von erfindungsgemäß ausgestatteten PC-TVs wird die interaktive Informationsübertragungsanlage in vorteilhafter Weise erweitert. Beim Einsatz von PC-TVs wird erreicht, daß alle Funktionen für den jeweils nächsten Benutzer voll zur Verfügung stehen und keine aufwendigen Wartungsmaßnahmen an den PC-TVs mehr notwendig sind, um die Betriebskonfiguration sicherzustellen und die vollständige Löschung sensibler Daten der Vorbenutzer zu gewährleisten.

### Bezugszeichen

- 1: Steuerung
- 2: Kopfstation
- 3: Signalquellenschalter und Modulator
- 4: Antennennetzwerk
- 5: Telefonanlage
- 6: TV im Gästezimmer
- 7: PC-TV im Gästezimmer
- 8: Festplatte mit für Benutzer unzugänglicher Basiskonfiguration
- 9: Festplatte für Benutzer zugänglich

## Patentansprüche

1. Interaktive Informationsübertragungsanlage umfassend eine Kopfstation (2), mindestens eine Steuerung (1), ein oder mehrere mit der Kopfstation verbundene Wiedergabegeräte und ein Antennennetzwerk (4), **dadurch gekennzeichnet, daß** die Wiedergabegeräte (6,7) mindestens ein PC-TV (7) umfassen, in welchem mindestens zwei Festplatten (8,9) angeordnet sind und eine Kopie der Basiskonfiguration des PC-TV auf einer Festplatte (8) abgelegt ist, die nur durch einen elektronischen Schalter mit dem PC-TV verbunden werden kann.

2. Interaktive Informationsübertragungsanlage nach Anspruch 1, **dadurch gekennzeichnet, daß** der elektronische Schalter auf einer Erweiterungskarte im PC-TV (7) angeordnet ist.

3. Interaktive Informationsübertragungsanlage nach Anspruch 2, **dadurch gekennzeichnet, daß** der elektronische Schalter auf der Erweiterungskarte im PC-TV (7) mit der Kopfstation (2) über ein Netzwerk (4) verbunden ist.

4. Interaktive Informationsübertragungsanlage nach den Ansprüchen 1 bis 3, **dadurch gekennzeichnet, daß** in einer ROM der Erweiterungskarte des PC-TV (7) eine Software zur Steuerung der Festplatte angeordnet ist.

## Claims

1. An interactive information transfer installation, comprising a head station (2), at least one control (1), one or more playback units connected with the head station, and an antenna network (4), **characterized in that** the playback units (6,7) comprise at least one PC-TV (7) having arranged therein at least two hard disks (8,9) and wherein a copy of the PC-TV base configuration is stored on one hard disk which can only be connected with the PC-TV by means of an electronic switch.

2. The interactive information transfer installation according to claim 1, **characterized in that** the electronic switch is arranged on an expansion board in said PC-TV (7).

3. The interactive information transfer installation according to claim 2, **characterized in that** the electronic switch on the expansion board in said PC-TV (7) is connected with the head station (2) via a network (4).

4. The interactive information transfer installation according to any of claims 1 to 3, **characterized in that** a software to control the hard disk is arranged in a ROM of the expansion board of said PC-TV (7).

## Revendications

1. Installation interactive de transmission d'informations, comprenant une station de tête (2), au moins une commande (1), un ou plusieurs appareils de reproduction reliés à ladite station de tête, et un réseau d'antennes (4), **caractérisée par le fait que** les appareils de reproduction (6, 7) comprennent au moins un ordinateur individuel-téléviseur (7) dans lequel sont disposés au moins deux disques durs (8, 9) et qu'une copie de la configuration de base de l'ordinateur individuel-téléviseur est mémorisée sur un disque dur qui ne peut être relié à l'ordinateur individuel-téléviseur que par un contacteur électronique.

2. Installation interactive de transmission d'informations selon la revendication 1, **caractérisée par le fait que** le contacteur électronique est disposé sur une carte d'extension dans l'ordinateur individuel-téléviseur (7).

3. Installation interactive de transmission d'informations selon la revendication 2, **caractérisée par le fait que** le contacteur électronique sur la carte d'extension dans l'ordinateur individuel-téléviseur (7) est relié à la station de tête (2) par un réseau (4).

4. Installation interactive de transmission d'informations selon les revendications 1 à 3, **caractérisée par le fait que** dans une mémoire ROM de la carte d'extension de l'ordinateur individuel-téléviseur (7) est disposé un logiciel pour la commande du disque dur.
